# EUROPÄISCHE PATENTSCHRIFT

(11) **EP 3 484 643 B1**
(45) Veröffentlichungstag und Bekanntmachung des Hinweises auf die Patenterteilung: **24.06.2020**
(21) Anmeldenummer: 17749351.7
(22) Anmeldetag: 20.06.2017
(51) Int. Cl.: B22F 3/26, C22C 26/00, C22C 29/04, C22C 29/06, C22C 29/08, C22C 29/10, B22F 3/24, B22F 5/00

(54) **VERFAHREN ZUM HERSTELLEN EINES HARTMETALLPRODUKTS UND HARTMETALLPRODUKT**
METHOD OF MANUFACTURING A HARDMETAL PRODUCT AND HARD METAL PRODUCT
PROCÉDÉ DE FABRICATION D'UN PRODUIT DE MÉTAL DUR ET PRODUIT DE MÉTAL DUR

(30) Priorität: 18.07.2016 AT 18216 U
(43) Veröffentlichungstag der Anmeldung: 22.05.2019
(73) Patentinhaber: Ceratizit Austria Gesellschaft m.b.H., 6600 Reutte (AT)
(72) Erfinder: ZHANG, Jiulai, 6600 Reutte (AT)
(74) Vertreter: Ciesla, Dirk
(86) Internationale Anmeldenummer: PCT/AT2017/000049
(87) Internationale Veröffentlichungsnummer: WO 2018/014054

(56) Entgegenhaltungen:
- WO-A1-2015/080237
- JP-A- H0 768 425
- US-A1- 2010 281 782
- US-A1- 2011 017 519
- US-A1- 2013 067 824

## Beschreibung

Die vorliegende Erfindung betrifft ein Verfahren zum Herstellen eines Hartmetallprodukts, ein Hartmetallprodukt sowie eine Verwendung eines solchen Hartmetallproduktes als Substrat zur Ausbildung einer polykristallinen Diamantbesciliciltung auf dessen Oberfläche,

Bei Werkzeugen für insbesondere eine zerspanende Bearbeitung von diversen Werkstoffen hat Hartmetall eine breite Anwendung gefunden. Bei Hartmetall (oftmals auch als "cemented carbide" bezeichnet) handelt es sich um einen Verbundwerkstoff, der überwiegend aus Hartstoffteilchen besteht, die in einen duktilen metallischen Binder als eine Matrix eingebettet sind. Der Anteil der Hartstoffteilchen in Gewichtsprozent übersteigt dabei den Anteil des duktilen metallischen Binders deutlich, meist sogar erheblich. Bei herkömmlichem Hartmetall kommt als Hartstoff üblicherweise WC (Wolframkarbid) zum Einsatz, es ist jedoch z.B. auch eine Verwendung von anderen Hartstoffteilchen, wie insbesondere TiC oder TiCN bekannt, wobei anstelle des Begriffs Hartmetall in letzterem Fall häufig der Begriff Cermet Verwendung findet. Neben den hauptsächlichen Hartstoffteilchen können in geringeren Mengen auch noch weitere Hartstoffteilchen in dem Hartmetall enthalten sein. Der duktile metallische Binder ist üblicherweise überwiegend durch Co, Ni, Fe oder eine Basislegierung von zumindest einem dieser Metalle gebildet, im Fall von WC als Hartstoff meistens durch Co oder eine Co-Basisiegierung. Unter einer Basislegierung eines Metalls ist dabei eine Legierung zu verstehen, bei der dieses Metall den Hauptbestandteil in Gewichtsprozent bildet.

Um die Leistungsfähigkeit von Werkzeugen aus Hartmetall weiter zu verbessern, werden heutzutage auf deren Oberfläche häufig Hartstoffbeschichtungen mittels eines CVD- (chemical vapor deposition) oder PVD-Prozesses (physical vapor deposition) abgeschieden. Insbesondere für eine Zerspanung von z.B. Faserverbundwerkstoffen oder einige metallische Werkstoffe wie Aluminiumsiliziumlegierungen kommen dabei vermehrt auch Beschichtungen aus polykristallinem Diamant zum Einsatz. Bei der Beschichtung von Hartmetallprodukten mit solchen Beschichtungen aus polykristallinem Diamant tritt aber das Problem auf, dass die Schichthaftung an der Oberfläche des Hartmetallprodukts oftmals nicht zufriedenstellend ist, was insbesondere im Fall des üblichen Co-haltigen metallischen Binders ein Problem darstellt.

WO 2015/080237 A1 beschreibt ein Verfahren nach dem Oberbegriff von Anspruch 1.

US 2013/0067824 A1 beschreibt ein Hartmetallprodukt nach dem Oberbegriff von Anspruch 11.

Es ist Aufgabe der vorliegenden Erfindung, ein verbessertes Verfahren zum Herstellen eines Hartmetallprodukts und ein verbessertes Hartmetallprodukt bereitzustellen, mit denen insbesondere auch eine verbesserte Haftung einer polykristallinen Diamantbeschichtung erreicht werden kann.

Die Aufgabe wird durch ein Verfahren zum Herstellen eines Hartmetallprodukts nach Anspruch 1 gelöst. Vorteilhafte Weiterbildungen sind in den abhängigen Ansprüchen angegeben.

Durch das selektive Entfernen des ersten metallischen Binders im Bereich der Oberfläche, was z.B. in an sich bekannter Weise durch einen chemischen Ätzprozess erfolgen kann, und die anschließende Infiltration mit dem zweiten metallischen Binder wird zuverlässig eine negative Beeinflussung der Schichthaftung durch den ersten Binder bei einem nachfolgenden Beschichtungsprozess verhindert. Ferner wird durch das Infiltrieren im Bereich der Oberfläche ein Verbundwerkstoff ausgebildet, bei dem die Hartstoffteilchen anstatt in den ersten metallischen Binder in den zweiten metallischen Binder eingebettet sind, der erste metallische Binder somit durch den zweiten metallischen Binder ersetzt ist. In dieser Weise wird die Ausbildung einer porösen Zwischenschicht vermieden, die bei einer selektiven Entfernung des ersten metallischen Binders und anschließender nur oberflächlicher Beschichtung mit einem zweiten metallischen Binder entstehen würde. Der zweite metallische Binder bildet eine zuverlässige Barriere zwischen dem ersten metallischen Binder und der aufzubringenden Beschichtung. Durch das Entfernen einer durchgängigen Schicht des zweiten metallischen Binders an der Oberfläche nach dem Infiltrieren wird eine gegenüber wirkenden Scherspannungen schwache Zwischenschicht aus dem zweiten metallischen Binder an der Oberfläche des Hartmetallprodukts verhindert.

Gemäß einer Weiterbildung sind die Hartstoffteilchen zumindest überwiegend durch WC gebildet und der erste metallische Binder ist durch Co, Ni oder eine Basislegierung von zumindest einem von Co und Ni gebildet. Insbesondere in diesem Fall weist das resultierende Hartmetallprodukt besonders vorteilhafte Eigenschaften auf. Der erste metallische Binder kann dabei insbesondere durch eine Co-Basislegierung gebildet sein, die außer den üblicherweise auftretenden weiteren Bestandteilen, wie etwas gelöstes W, Cr o.ä., fast ausschließlich durch Co gebildet ist.

Gemäß einer Weiterbildung erfolgt das selektive Entfernen des ersten metallischen Binders im Bereich der Oberfläche durch chemisches oder elektrochemisches Ätzen. In diesem Fall kann der erste metallische Binder zuverlässig ausgehend von der Oberfläche bis zu einer Tiefe entfernt werden, die die mittlere Korngröße der Hartstoffteilchen übersteigt, sodass bei der anschließenden Infiltration mit dem zweiten metallischen Binder zuverlässig ein Verbundwerkstoff mit in dem zweiten metallischen Binder eingebetteten Hartstoffteilchen ausgebildet werden kann.

Das Infiltrieren erfolgt erfindungsgemäß bei einer Temperatur unterhalb des Schmelzpunkts des ersten metallischen Binders und oberhalb des Schmelzpunkts des zweiten metallischen Binders. In dieser Weise wird zuverlässig erreicht, dass keine poröse Zwischenschicht ausgebildet wird, es wird gleichzeitig eine erhöhte Konzentration des ersten metallischen Binders unmittelbar an der Oberfläche zuverlässig unterbunden.

Gemäß einer Weiterbildung ist der zweite metallische Binder Cu oder eine Cu-Basislegierung. Insbesondere in diesem Fall wird eine besonders günstige Voraussetzung für eine anschließende Beschichtung mit polykristallinem Diamant geschaffen.

Gemäß einer Weiterbildung erfolgt das selektive Entfernen des ersten metallischen Binders bis zu einer Tiefe von zumindest 2 µm von der Oberfläche, bevorzugt zumindest 5 µm, mehr bevorzugt zumindest 10 µm. In diesem Fall wird in dem Bereich der Oberfläche des Hartmetallproduktes zuverlässig ein Verbundwerkstoff ermöglicht, bei dem die Hartstoffteilchen in den zweiten metallischen Binder eingebettet sind.

Gemäß einer Weiterbildung erfolgt nach dem Entfernen der durchgängigen Schicht des zweiten metallischen Binders an der Oberfläche ein selektives Ätzen von Hartstoffteilchen, sodass Stege aus dem zweiten metallischen Binder aus der Oberfläche herausragen. In diesem Fall wird besonders zuverlässig eine gute Haftung einer polykristallinen Diamantbeschichtung ermöglicht, bei der die durch Hartstoffteilchen gebildeten Bereiche der Oberfläche aufgeraut sind und sich hervorstehende Stege des zweiten metallischen Binders zwischen die aufwachsenden Diamantkörner erstrecken.

Das Entfernen der durchgängigen Schicht des zweiten metallischen Binders an der Oberfläche erfolgt erfindungsgemäß derart, dass an der Oberfläche ein Verbundwerkstoff, bei dem die Hartstoffteilchen in ein überwiegend durch den zweiten metallischen Binder gebildetes Material eingebettet sind, mit einer Schichtdicke verbleibt, die größer als die mittlere Korngröße der eingebetteten Hartstoffteilchen ist, bevorzugt ≥ 1 µm, mehr bevorzugt ≥ 3 µm ist. In diesem Fall werden eine besonders gute Schichthaftung und ein besonders stabiler Gesamtaufbau erreicht.

Gemäß einer Weiterbildung erfolgt nach dem Entfernen der durchgängigen Schicht des zweiten metallischen Binders an der Oberfläche eine Beschichtung der Oberfläche mit einer polykristallinen Diamantbeschichtung. Bevorzugt erfolgt diese Beschichtung erst nach einem vorangehenden selektiven Ätzen von Hartstoffteilchen. In diesem Fall wird ein besonders zuverlässiges diamantbeschichtetes Hartmetallprodukt bereitgestellt. Die Haftung der Diamantbeschichtung kann ferner durch Aufrauen des Körpers durch Sandstrahlen oder Ätzen vor oder nach der Infiltration weiter erhöht werden, um eine noch größere Rauheit zu erreichen.

Die Aufgabe wird auch durch ein Hartmetallprodukt nach Anspruch 9 gelöst. Vorteilhafte Weiterbildungen sind in den abhängigen Ansprüchen angegeben.

Da die Dicke des aus dem Verbundwerkstoff bestehenden Bereichs die mittlere Korngröße der eingebetteten Hartstoffteilchen übersteigt, wird ein stabiler und zuverlässiger, kontinuierlicher Übergang zwischen dem aus Hartmetall mit dem ersten metallischen Binder bestehenden Kern und dem Oberflächenbereich aus dem Verbundwerkstoff mit dem zweiten metallischen Binder erreicht. Ferner wird zuverlässig eine negative Beeinflussung der Haftung einer Diamantbeschichtung durch den ersten metallischen Binder verhindert. Das Hartmetallprodukt ist dabei frei von einer porösen Schicht zwischen dem Kern und der Oberfläche. Bevorzugt kann die Dicke des Oberflächenbereichs zumindest doppelt so groß wie die mittlere Korngröße der Hartstoffteilchen sein. Die mittlere Korngröße der Hartstoffteilchen kann in allgemein bekannter Weise z.B. aus einem metallurgischen Schliff bestimmt werden. Ferner kann die Dicke des Oberflächenbereichs aus dem Verbundwerkstoff im Verhältnis zur mittleren Korngröße der Hartstoffteilchen z.B. in einfacher Weise unmittelbar lichtmikroskopisch aus einem metallurgischen Schliff erkannt werden. Das Hartmetallprodukt kann insbesondere z.B. ein Zerspanungswerkzeug oder ein Rohling für ein Zerspanungswerkzeug sein, insbesondere eine rotierendes Zerspanungswerkzeug, wie ein Bohrer oder Fräser oder ähnliches, oder ein Rohling für ein solches.

Gemäß einer Weiterbildung ist die Oberfläche des Körpers frei von einer durchgängigen Schicht des zweiten metallischen Binders. Im Fall eines beschichteten Hartmetallkörpers ist unter der Oberfläche des Körpers die Oberfläche des unter der Beschichtung befindlichen, als Substrat dienenden Hartmetallkörpers zu verstehen. Die Abwesenheit der durchgängigen Schicht des zweiten metallischen Binders ermöglicht eine gegenüber Scherspannungen besonders stabile Ausbildung eines mit polykristailinem Diamant beschichteten Hartmetallkörpers. Der Oberflächenbereich aus dem Verbundwerkstoff weist bevorzugt im Wesentlichen dieselbe Gefügestruktur wie das Hartmetall des Hartmetallkörpers in einem weiter von der Oberfläche entfernten Bereich auf.

Gemäß einer Weiterbildung sind die Hartstoffteilchen zumindest überwiegend durch WC gebildet und der erste metallische Binder ist durch Co, Ni oder eine Basislegierung von zumindest einem von Co und Ni gebildet. In diesem Fall wird ein besonders vorteilhafter Hartmetallkörper bereitgestellt.

Wenn der zweite metallische Binder Cu oder eine Cu-Basisiegierung ist, wird ein besonders vorteilhaftes und kostengünstiges Substrat für eine nachfolgende Beschichtung mit polykristailinem Diamant bereitgestellt,

Gemäß einer Weiterbildung ist auf der Oberfläche des Körpers eine polykristalline Diamantbeschichtung ausgebildet, sodass ein besonders zuverlässiges diamantbeschichtetes Hartmetallprodukt bereitgestellt ist. Gemäß einer Weiterbildung ragen Stege aus dem zweiten metallischen Binder aus der Oberfläche heraus und sind in der polykristallinen Diamantbeschichtung eingebettet. In diesem Fall wird eine besonders stabile Verankerung der Diamantbeschichtung erzielt, Die Erstreckung des zweiten Binders in der Diamantbeschichtung in der Richtung parallel zur Oberfläche entspricht zumindest im Wesentlichen der des zweiten Binders in dem Verbundwerkstoff mit den eingebetteten Hartstoffteilchen. In dieser Weise wird eine zähe Verbindung zwischen dem Hartmetalisubstrat und der Diamantbeschichtung erzielt. Die Haftung der Diamantbeschichtung ist durch die erzielte Reduzierung des Unterschieds im thermischen Ausdehnungskoeffizienten zwischen Hartmetall und Diamantbeschichtung sowie durch die mechanische Verklemmung dieser Stege in der Diamantbeschichtung verbessert. Die Reduzierung des Unterschieds im thermischen Ausdehnungskoeffizienten wird durch den in der Diamantbeschichtung eingebetteten zweiten metallischen Binder erzielt, der einen hohen thermischen Ausdehnungskoeffizienten hat und den sehr niedrigen thermischen Ausdehnungskoeffizienten von Diamant kompensiert.

Die Aufgabe wird auch durch eine Verwendung eines solchen Hartmetallprodukts nach Anspruch 15 als Substrat zur Ausbildung einer polykristallinen Diamantbeschichtung auf dessen Oberfläche gelöst.

Weitere Vorteile und Zweckmäßigkeiten der Erfindung ergeben sich anhand der nachfolgenden Beschreibung von Ausführungsbeispielen unter Bezugnahme auf die beigefügten Figuren.

Von den Figuren zeigen:
- Fig. 1:: eine schematische Darstellung eines Hartmetaitprodukts gemäß einer Ausführungsform;
- Fig. 2:: eine lichtmikroskopische Aufnahme eines metallurgischen Schliffs eines Hartmetaliprodukts nach dem Schritt des Infiltrierens;
- Fig. 3:: eine lichtmikmskopische Aufnahme eines metallurgischen Schliffs eines Hartmetallprodukts nach dem Entfernen einer durchgängigen Schicht des zweiten Binders und nach an einem anschließenden selektiven Ätzen von Hartstofffeiichen; und
- Fsg. 4:: eine lichtmikroskopische Aufnahme eines metallurgischen Schliffs eines Hartmetallprodukts gemäß einem nicht erfindungsgemäßen Vergleichsöeispiel.

### AUSFÜHRUNGSFORM

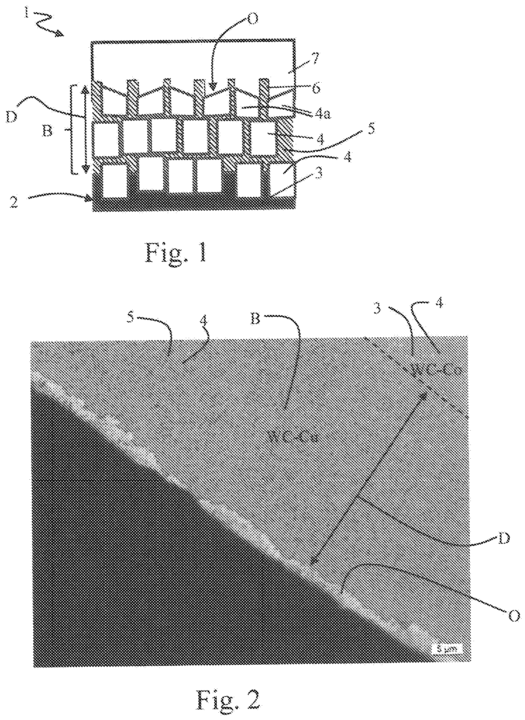

Eine Ausführungsform wird im Folgenden unter Bezugnahme auf die Fig. 1 bis Fig. 3 eingehender beschrieben.

Fig. 1 ist eine schematische Darstellung eines Hartmetallprodukts 1 gemäß der Ausführungsform. Das Hartmetallprodukt 1 weist einen Körper 2 aus Hartmetall auf, von dem in Fig. 1 nur ein oberflächennaher Bereich gezeigt ist. Das Hartmetall ist aus in einen duktilen ersten metallischen Binder 3 eingebettete Hartstoffteilchen 4 gebildet, die zumindest überwiegend durch WC (Wolframkarbid) oder TiCN (Titankarbonitrid) gebildet sind. Neben diesen hauptsächlichen Hartstoffteilchen können in an sich bekannter Weise in geringeren Mengen auch noch andere Hartstoffteilchen vorhanden sein. Der erste metallische Binder ist durch Co, Ni, Fe oder eine Basislegierung von zumindest einem von Co, Ni und Fe gebildet, bevorzugt durch Co, Ni oder eine Basislegierung von zumindest einem von Co und Ni.

In einem Oberflächenbereich B des Hartmetallprodukts 1 ist der zuvor beschriebene erste metallische Binder 3 durch einen von dem ersten metallischen Binder 3 verschiedenen zweiten metallischen Binder 5 ersetzt, sodass in diesem Öberflächenbereich B ein Verbundwerkstoff gebildet ist, bei dem die Hartstoffteilchen 4 in dem zweiten metallischen Binder 5 eingebettet sind. Die Gefügestruktur des Verbundwerkstoffs in dem Oberflächenbereich B unterscheidet sich dabei nicht wesentlich von der Gefügestruktur des Hartmetalls in dem Kernbereich, in dem die Hartstoffteilchen 4 in den ersten metallischen Binder 3 eingebettet sind. Der zweite metallische Binder 5 ist durch Cu, Ag oder durch eine Basislegierung von zumindest einem von Cu und Ag gebildet, bevorzugt durch Cu oder eine Cu-Basislegierung. Der Gehalt von Cu und/oder Ag an dem zweiten metallischen Binder 5 beträgt bevorzugt zumindest 80 Gew.-%. Das Hartmetall in dem Kernbereich geht ohne eine dazwischen befindliche poröse Zwischenschicht in den Verbundwerkstoff des Oberflächenbereichs B über, sodass das Hartmetallprodukt 1 frei von einer porösen Zwischenschicht ist. Der Oberflächenbereich B hat in der Richtung senkrecht zur Oberfläche des Hartmetallprodukts 1 eine Dicke D, die größer als die mittlere Korngröße der eingebetteten Hartstoffpartikel 4 ist. Bevorzugt ist die Dicke D zumindest doppelt so groß wie die mittlere Korngröße der eingebetteten Hartstoffteilchen 4. Die Dicke D beträgt bei der Ausführungsform zumindest 1 µm, bevorzugt zumindest 3 µm, mehr bevorzugt zumindest 5 µm, Der zweite metallische Binder 5 kann in einer Abwandlung ferner auch noch ein oder mehrere carbildbildende Elemente, insbesondere Si und/oder Ti, enthalten.

Die Oberfläche O des Körpers 2 ist frei von einer durchgängigen Schicht des zweiten metallischen Binders 5. Es sind in einer Richtung parallel zu der Oberfläche O des Körpers 2 insbesondere weniger als 1 0% Flächenanteil der Oberfläche, aber bevorzugt keine Flächen des zweiten metallischen Binders 5 ausgebildet, die wesentlich größer als die Flächen des ersten metallischen Binders 3 in dem Kernbereich (Bindersee im Kernbereich) sind. Einzelne große Flächen des zweiten metallischen Binders 5 können ggfs. aufgrund einer nicht vollständigen Entfernung der ununterbrochenen Schicht des zweiten metallischen Binders 5 entstehen. Die Hartstoffteilchen 4a an der Oberfläche O des Körpers 2 sind angeätzt, sodass diese gegenüber den Hartstoffteilchen 4 auf einer geschliffenen Oberfläche eine etwas rauere, vergrößerte Oberfläche aufweisen. Zwischen diesen angeätzten Hartstoffteilchen 4a sind Stege 6 des zweiten metallischen Binders 5 ausgebildet die aus der Oberfläche O des Körpers 2 herausragen.

Auf der Oberfläche O des derart ausgebildeten Hartmetallprodukts als Substrat ist bei der Ausführungsform in an sich bekannter Weise mittels eines CVD-Prozesses eine polykristalisne Diamantbeschichtung 7 abgeschieden, wie in Fig. 1 ebenfalls schematisch dargestellt ist. Die von der Oberfläche O hervorstehenden Stege 6 des zweiten metallischen Binders 5 sind in der polykristallinen Diamantbeschichtung eingebettet, sodass über diese und die aufgerauten Hartstoffteilchen 4a an der Oberfläche O eine gute mechanische Verklemmung zwischen der Oberfläche des Körpers 2 und der darauf ausgebildeten polykristallinen Diamantbeschichtung 7 erzielt ist. Aufgrund der Einbettung der Stege 6 in die polykristalline Diamantbeschichtung 7 ist ferner ein geringer Unterschied im thermischen Ausdehnungskoeffizienten zwischen der Diamantbeschichtung 7 und dem Oberflächenbereich des als Substrat dienenden Hartmetallprodukts 1 gegeben, was sich ebenfalls vorteilhaft auf die Haftung der Diamantbeschichtung 7 auswirkt.

Obwohl in Bezug auf die Ausführungsform in Fig. 1 schematisch ein Hartmetallprodukt 1 mit einem Körper 2 dargestellt ist, auf dem bereits eine polykristalline Diamantbeschichtung 7 aufgebracht ist. ist dies nicht zwingend erforderlich, sondern das Hartmetallprodukt 1 kann auch ohne die polykristalline Diamantbeschichtung 7 ausgebildet sein, insbesondere z.B. als Rohling, der als Substrat für eine anschließende Diamantbeschichtung oder eine Bedchichtung mit einer keramischen Hartstoffschicht dient.

Bei einem Verfahren zum Herstellen des zuvor beschriebenen Hartmetallprodukts 1 wird zunächst der Körper 2 in bekannter Weise in einem pulvermetallurgischen Verfahren durch Mischen von entsprechenden Ausgangspulvern für den ersten metallischen Binder 3 und für die Hartstoffteilchen 4, durch anschließendes Pressen und Sintern zu einem dichten Hartrnetallbauteil erzeugt. Der derart gefertigte Körper 2 aus Hartmetall weist in den ersten metallischen Binder 3 eingebettete Hartstoffteilchen 4 auf. Der Körper 2 aus Hartmetall kann anschließend zum Beispiel in einer Schieifbehandlung bearbeitet werden, um eine gewünschte Form zu erzielen. Z.B. können dabei einige Bereich rundgeschliffen werden, es können Schneidkanten o.ä. ausgebildet werden etc.

In einem anschließenden Schritt wird der Körper 2 in einem chemischen oder elektrochemischen Ätzverfahren, das z.B. mit HNO₃ (Salpetersäure) oder einer Mischung aus H₂SO₄ (Schwefelsäure) und H₂O₂ (Wasserstoffperoxid) durchgeführt werden kann, behandelt, um in einem Oberflächenbereich B den ersten metallischen Binder 3 zu entfernen. Dort verbleiben im Wesentlichen nur die Hartstoffteilchen 4. Dabei wird der erste metallische Binder 3 somit im Bereich der Oberfläche O des Hartmetalls selektiv entfernt und die Hartstoffteilchen 4 in diesem Bereich werden freigelegt. Die Dauer des Ätzverfahrens wird dabei derart gewählt, dass das selektive Entfernen des ersten metallischen Binders 3 bis zu einer Tiefe von zumindest 2 µm von der Oberfläche O erfolgt, bevorzugt bis zumindest 5 µm, mehr bevorzugt bis zumindest 10 µm, zumindest aber bis zu einer Tiefe, die größer als die mittlere Korngröße der Hartstoffteilchen 4 ist.

Anschließend erfolgt eine Infiltration des derart behandelten Körpers 2 mit dem Material des zweiten metallischen Binders 5. Dazu wird zunächst das Material des zweiten metallischen Binders 5 auf die Oberfläche O aufgebracht, was z.B. in Form von Pulver oder als eine Folie, aber auch z.B. als eine Beschichtung, insbesondere eine galvanische Beschichtung erfolgen kann. Anschließend erfolgt eine Temperaturbehandlung bei einer Temperatur, die oberhalb des Schmelzpunktes des zweiten metallischen Binders 5 aber unterhalb des Schmelzpunktes des ersten metallischen Binders 3 erfolgt. Alternativ zu dem zuvor beschriebenen Vorgehen, kann die Infiltration z.B. auch durch Eintauchen des Körpers 2 in eine Schmelze des zweiten metallischen Binders 5 erfolgen.

Nach dem Infiltrieren wird eine durchgängige Schicht des zweiten metallischen Binders 5 an der Oberfläche O des Körpers 2 - sofern vorhanden - entfernt. Dies kann z.B. durch eine mechanische Strahlbehandlung mit einem Strahlmedium, durch Bürsten, durch Schleifen, etc. erfolgen. Durch das beschriebene Vorgehen wird erreicht, dass der Körper 2 an der Oberfläche O frei von einer durchgängigen Schicht aus dem zweiten metallischen Binder 5 ist und dass an der Oberfläche O ein Verbundwerkstoff ausgebildet wird, bei dem die Hartstoffteüchen 4 in ein überwiegend durch den zweiten metallischen Binder 5 gebildetes Material eingebettet sind. Bei dem Infiltrieren können in geringeren Menge auch andere Elemente in dem Ausgangsmaterial für den zweiten metallischen Binder 5 in Lösung gehen, z.B. in geringen Mengen ggfs. Bestandteile des ersten metallischen Binders 3, Wolfram aus den Hartstoffpartikeln 4, etc. Der Verbundwerkstoff mit dem zweiten metallischen Binder 5 weist eine Schichtdicke D auf, die größer als die mittlere Korngröße der eingebetteten Hartstoffteilchen 4 ist, bevorzugt ≥ 1 µm, mehr bevorzugt ≥ 3 µm ist.

Das derart ausgebildete Hartmetaliprodukt 1, bei dem an der Oberfläche O ausgebildeten Verbundwerkstoff mit dem zweiten metallischen Binder 5 eignet sich besonders gut für eine anschließende Beschichtung mit polykristallinem Diamant. Es sind jedoch auch andere Anwendungen, z.B. als unbeschichtetes Zerspanungswerkzeug oder als Zerspanungswerkzeug mit einer anderen CVD- oder PVD-Beschichtung möglich. In diesen Fällen äußert sich der Verbundwerkstoff an der Oberfläche O vorteilhaft durch eine verbesserte Wärmeleitfähigkeit und folglich eine höhere Wärmeschockfestigkeit, wobei die hohe Biegefestigkeit des Hartmetalls mit in den ersten metallischen Binder 3 eingebetteten Hartstoffteilchen 4 insgesamt zumindest weitgehend erhalten bleibt.

Zur Vorbereitung für eine anschließende Beschichtung mit polykristallinem Diamant kann bevorzugt nach dem Infiltrieren und Entfernen der durchgängigen Schicht des zweiten metallischen Binders 5 eine Ätzbehandlung erfolgen, bei der an der Oberfläche ein selektives Ätzen von Hartstoffteilchen 4 erfolgt. Das selektive Ätzen kann dabei insbesondere mittels des in der Hartmetallindustrie weitverbreiteten Murakami-Ätzmittels (H₂0 + KOH + K₃[Fe(CN₆)]) erfolgen, Ein Ätzen mit anderen Chemikalien oder mittels elektrochemischer Verfahren ist aber z.B. auch möglich, Dieses selektive Ätzen resultiert in einer raueren Oberfläche der verbleibenden Hartstoffteilchen 4a an der Oberfläche O des Körpers 2 sowie in von der Oberfläche O hervorstehenden Stegen 6 des zweiten metallischen Binders 5, was sich jeweils vorteilhaft auf die Anbindung der nachfolgend aufzubringenden polykristallinen Diamantbeschichtung 7 auswirkt.

Die nachfolgende Beschichtung mit polykristallinem Diamant erfolgt in der üblichen Weise, z.B. mit einer sogenannten Hot-Filament-Methode, wobei z.B. auch auf die kommerziell erhältlichen derartigen Beschichtungsangebote zurückgegriffen werden kann.

### BEISPIEL 1

Hartmetallprodukte 1 mit einem Körper aus Hartmetall mit sub-mikron WC als Hartstoffteilchen 4 und einem Co-Gehalt von 10 Gew.-% als erster metallischer Binder 3 wurden zunächst für einen Zeitraum von ein, drei, fünf bzw. sieben Stunden in 65 %iger HNO₃ bei Raumtemperatur geätzt. Es hat sich gezeigt, dass die Dicke eines Oberflächenbereichs, in dem der erste metallische Binder 3 unter Freilegung der Hartstoffteilchen 4 entfernt wird, mit zunehmender Dauer des Ätzprozesses zunimmt. Bei dem Beispiel wurde eine Zunahme von einer Dicke D von ca. 10 µm nach einer Stunde auf etwa 40 µm nach sieben Stunden beobachtet.

Für eine Infiltration mit Cu als zweitem metallischem Binder 5 wurden die derart vorbereiteten Hartmetallprodukte 1 mit Cu-Pulver bestrichen und in Wasserstoffatmosphäre auf 1150°C erhitzt, um das Cu-Pulver zu schmelzen und das flüssige Cu in den oberflächennahen Bereich zu infiltrieren.

Mikroskopische Untersuchungen haben ergeben, dass sich an der Oberfläche O des Hartmetallkörpers 2 eine im Wesentlichen gleichmäßige Schicht des zweiten metallischen Binders 5 ausbildet und dass die durch den vorhergehenden Ätzprozess des ersten metallischen Binders 3 gebildeten Hohlräume durch den zweiten metallischen Binder 5 gefüllt wurden, sodass sich ohne eine zwischen dem Kern aus Hartmetall und dem Oberflächenbereich befindliche poröse Zwischenschicht an der Oberfläche O ein Verbundwerkstoff ausgebildet hat, bei dem der erste metallische Binder 3 durch den zweiten metallischen Binder 5 (hier Cu) ersetzt ist. Eine chemische Analyse hat ergeben, dass der zweite metallische Binder 5 nahe der Oberfläche nur einen Anteil von 0,5 - 0,9 Gew,-% (bezogen auf den gesamten WC-Cu-Verbundwerkstoff) des ersten metallischen Binders 3 (hier Co) aufwies. Eine lichtmikroskopische Aufnahme eines metallurgischen Schliffes in einem Bereich an einer Oberfläche O eines solchen infiltrierten Hartmetaliproduktes 1 ist. in Fig. 2 zu sehen. Es ist zu erkennen, dass zwischen dem Oberflächenbereich B und dem Kern des Hartmetallproduktes 1 keine poröse Zwischenschicht ausgebildet ist.

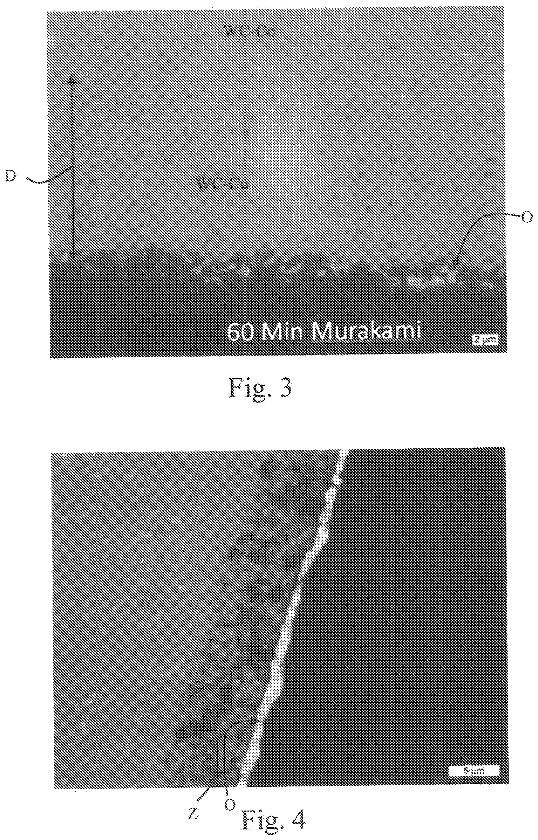

Die in Fig. 2 zu erkennende, an der Oberfläche O ausgebildete durchgängige Schicht des zweiten metallischen Binders 5 wurde anschließend durch eine mechanische Strahlbehandlung entfernt. Die derart behandelten Hartmetallprodukte 1 wiesen eine durch die Hartstoffteilchen 4 geprägte silbrigglänzende Oberfläche auf. Bei einer anschließenden Ätzbehandlung mit Murakami-Lösung für 15, 30 und 60 Minuten erhielten die behandelten Hartmetallprodukte 1 jeweils eine im Wesentlichen durch den zweiten metallischen Binder 5 geprägte kupferfarbene Oberfläche und es konnte eine Zunahme von aus der Oberfläche O ragenden Stegen 6 aus dem zweiten metallischen Binder 5 beobachtet werden. Eine lichtmikroskopische Aufnahme eines metallurgischen Schliffes eines derart behandelten Hartmetallprodukts 1 mit 60 Minuten Ätzzeit ist in Fig. 3 zu sehen.

Die derart behandelten Hartmetaliprodukte 1 wurden anschließend als Substrate für eine nachfolgende Beschichtung mit polykristallinem Diamant verwendet.

### VERGLEICHSBEISPIEL

Bei einem Vergieichsbeispiel wurden Hartmetallprodukte aus demselben Ausgangsmaterial wie bei Beispiel 1 für vier Minuten mit 4-prozentiger CuSO₄-Lösung behandelt. Es wurde die Bildung einer ca. 2 µm dicken Cu-Schicht mit Cu-Kristallen an der Oberfläche beobachtet. Gleichzeitig bildete sich unterhalb dieser Cu-Schicht eine im Wesentlichen binderfreie poröse Schicht.

Anschließend wurden diese Hartmetallprodukte für zehn Stunden bei 825°C in Wasserstoffatmosphäre geglüht. Bei den derart behandelten Hartmetallprodukten füllten sich zwar einige der Poren der im Wesentlichen binderfreien porösen Schicht mit Cu und auf der Oberfläche bildete sich eine wesentliche glattere Cu-Schicht aus, in Richtung des Inneren des Hartmetallkörpers 1 blieb aber weiterhin eine poröse Zwischenschicht Z erkennbar. Eine lichtmikroskopische Aufnahme des derart behandelten Hartmetaliprodukts ist in Fig. 4 zu sehen, wobei die verbleibende poröse Zwischenschicht Z deutlich zu erkennen ist.

### BEISPIEL 2

Entsprechend dem Vorgehen bei Beispiel 1 wurden Proben aus Hartmetall mit WC als Hartstöffteilchen 4 und 10 Gew.-% Co als erster metallischer Binder 3 mit 65 %-iger HNO₃ geätzt und anschließend in Wasserstoffatmosphäre für 10 Minuten bei 1150°C mit Cu infiltriert. Bei einer Probendicke von ca. 3,2 mm wurde ein Oberflächenbereich B mit einer Dicke von ca, 80 µm aus einem Verbundwerkstoff erzielt, bei dem die WC-Hartteilchen in einen überwiegend aus Cu bestehenden zweiten metallischen Binder 5 eingebettet sind. Das erzielte Hartmetallprodukt 1 war wiederum frei von einer porösen Zwischenschicht

Untersuchungen der Biegebruchfestigkeit ergaben eine Biegebruchfestigkeit von ca. 2900 MPa, die zwar unterhalb der Biegebruchfestigkeit des entsprechenden reinen Hartmetalls von 4000 MPa lagen, aber dennoch ausreichend hoch waren.

## Patentansprüche

1. Verfahren zum Herstellen eines Hartmetallprodukts (1), mit den Schritten:
- pulvermetallurgisches Herstellen eines Hartmetalls mit in einen duktilen ersten metallischen Binder (3) eingebetteten Hartstoffteilchen (4), wobei die Hartstoffteilchen (4) zumindest überwiegend durch WC oder TiCN gebildet sind und der erste metallische Binder (3) durch Co, Ni, Fe oder eine Basislegierung von zumindest einem von Co, Ni, Fe gebildet ist,
- selektives Entfernen des ersten metallischen Binders (3) im Bereich der Oberfläche (O) des Hartmetalls unter zumindest oberflächennaher Freilegung der Hartstoffteilchen (4) in diesem Bereich,
**gekennzeichnet durch**:
- Infiltrieren der freigelegten Hartstoffteilchen (4) mit zumindest einem von Cu, Ag oder einer Basislegierung von Cu oder Ag als einem zweiten metallischen Binder (5) bei einer Temperatur unterhalb des Schmelzpunkts des ersten metallischen Binders (3) und oberhalb des Schmelzpunkts des zweiten metallischen Binders (5), und
- Entfernen einer durchgängigen Schicht des zweiten metallischen Binders (5) an der Oberfläche (O) derart, dass an der Oberfläche (O) ein Verbundwerkstoff, bei dem die Hartstoffteilchen (4) in ein überwiegend durch den zweiten metallischen Binder (5) gebildetes Material eingebettet sind, mit einer Schichtdicke (D) verbleibt, die größer als die mittlere Korngröße der eingebetteten Hartstoffteilchen (4) ist, bevorzugt ≥ 1 µm, mehr bevorzugt ≥ 3 µm ist.

2. Verfahren nach Anspruch 1, wobei die Hartstoffteilchen (4) zumindest überwiegend durch WC gebildet sind und der erste metallische Binder (3) durch Co, Ni oder eine Basislegierung von zumindest einem von Co und Ni gebildet ist.

3. Verfahren nach Anspruch 1 oder 2, wobei das selektive Entfernen des ersten metallischen Binders (3) im Bereich der Oberfläche (O) durch chemisches oder elektrochemisches Ätzen erfolgt.

4. Verfahren nach einem der vorangehenden Ansprüche, wobei der zweite metallische Binder (5) Cu oder eine Cu-Basislegierung ist.

5. Verfahren nach einem der vorangehenden Ansprüche, wobei das selektive Entfernen des ersten metallischen Binders (3) bis zu einer Tiefe von zumindest 2 µm von der Oberfläche (O) erfolgt, bevorzugt zumindest 5 µm, mehr bevorzugt zumindest 10 µm.

6. Verfahren nach einem der vorangehenden Ansprüche, wobei nach dem Entfernen der durchgängigen Schicht des zweiten metallischen Binders (5) an der Oberfläche ein selektives Ätzen von Hartstoffteilchen (4) erfolgt, sodass Stege (6) aus dem zweiten metallischen Binder (5) aus der Oberfläche (O) herausragen.

7. Verfahren nach einem der vorangehenden Ansprüche, wobei nach dem Entfernen der durchgängigen Schicht des zweiten metallischen Binders (5) an der Oberfläche (O) eine Beschichtung der Oberfläche (O) mit einer polykristallinen Diamantbeschichtung (7) erfolgt.

8. Verfahren nach Anspruch 7, wobei die Beschichtung nach einem selektiven Ätzen von Hartstoffteilchen (4) erfolgt.

9. Hartmetallprodukt (1), herstellbar nach einem Verfahren nach einem der Ansprüche 1 bis 8, mit:
einem Körper (2) aus Hartmetall mit in einen duktilen ersten metallischen Binder (3) eingebetteten Hartstoffteilchen (4), wobei die Hartstoffteilchen (4) zumindest überwiegend durch WC oder TiCN gebildet sind und der erste metallische Binder (3) durch Co, Ni, Fe oder eine Basislegierung von zumindest einem von Co, Ni, Fe gebildet ist,
**gekennzeichnet durch**
einen Oberflächenbereich (B) des Körpers (2) mit einer Dicke (D), die größer als die mittlere Korngröße der eingebetteten Hartstoffteilchen (4),
bevorzugt größer als das Zweifache der mittleren Korngröße der eingebetteten Hartstoffteilchen (4), ist, aus einem Verbundwerkstoff, bei dem die Hartstoffteilchen (4) in einen zweiten metallischen Binder (5) eingebettet sind, der zumindest eines von Cu und Ag als Hauptbestandteil aufweist.

10. Hartmetallprodukt nach Anspruch 9, wobei die Oberfläche (O) des Körpers (2) frei von einer durchgängigen Schicht des zweiten metallischen Binders (5) ist.

11. Hartmetallprodukt nach Anspruch 9 oder 10, wobei die Hartstoffteilchen (4) zumindest überwiegend durch WC gebildet sind und der erste metallische Binder (3) durch Co, Ni oder eine Basislegierung von zumindest einem von Co und Ni gebildet ist.

12. Hartmetallprodukt nach einem der Ansprüche 9 bis 11, wobei der zweite metallische Binder (5) Cu oder eine Cu-Basislegierung ist.

13. Hartmetallprodukt nach einem der Ansprüche 9 bis 12, wobei auf der Oberfläche (O) des Körpers (2) eine polykristalline Diamantbeschichtung (7) ausgebildet ist.

14. Hartmetallprodukt nach Anspruch 13, wobei Stege (6) aus dem zweiten metallischen Binder (5) aus der Oberfläche (O) herausragen und in der polykristallinen Diamantbeschichtung (7) eingebettet sind.

15. Verwendung eines Hartmetallprodukts nach einem der Ansprüche 9 bis 12 als Substrat zur Ausbildung einer polykristallinen Diamantbeschichtung (7) auf dessen Oberfläche (O).

## Claims

1. Process for the production of a cemented-carbide product (1) with the steps of:
- powder-metallurgical production of a cemented carbide with hard-material particles (4) embedded in a ductile first metallic binder (3), where the hard-material particles (4) are at least predominantly formed by WC or TiCN and the first metallic binder (3) is formed by Co, Ni, Fe or a base alloy of at least one of Co, Ni, Fe,
- selective removal of the first metallic binder (3) in the region of the surface (O) of the cemented carbide with, at least in the vicinity of the surface, exposure of the hard-material particles (4) in the said region,
**characterized by**:
- infiltration of the exposed hard-material particles (4) with at least one of Cu, Ag or a base alloy of Cu or Ag as a second metallic binder (5) at a temperature below the melting point of the first metallic binder (3) and above the melting point of the second metallic binder (5), and
- removal of any continuous layer of the second metallic binder (5) at the surface (O) in a manner such that a composite material comprising the hard-material particles (4) embedded into a material predominantly formed by the second metallic binder (5) remains at the surface (O) and has a layer thickness (D) that is greater than the average grain size of the embedded hard-material particles (4), preferably ≥ 1 µm, more preferably ≥ 3 µm.

2. Process according to Claim 1, where the hard-material particles (4) are at least predominantly formed by WC, and the first metallic binder (3) is formed by Co, Ni or a base alloy of at least one of Co and Ni.

3. Process according to Claim 1 or 2, where the selective removal of the first metallic binder (3) in the region of the surface (O) is achieved by chemical or electrochemical etching.

4. Process according to any of the preceding claims, where the second metallic binder (5) is Cu or a Cu base alloy.

5. Process according to any of the preceding claims, where the selective removal of the first metallic binder (3) extends to a depth of at least 2 µm from the surface (O), preferably at least 5 µm, more preferably at least 10 µm.

6. Process according to any of the preceding claims where, after the removal of the continuous layer of the second metallic binder (5) at the surface, selective etching of hard-material particles (4) takes place in a manner such that projections (6) made of the second metallic binder (5) protrude from the surface (O).

7. Process according to any of the preceding claims where, after the removal of the continuous layer of the second metallic binder (5) at the surface (O), the surface (O) is coated with a polycrystal diamond coating (7).

8. Process according to Claim 7, where the coating takes place after selective etching of hard-material particles (4).

9. Cemented-carbide product (1) which can be produced by a process according to any of Claims 1 to 8, with:
a body (2) made of cemented carbide with hard-material particles (4) embedded in a ductile first metallic binder (3), where the hard-material particles (4) are at least predominantly formed by WC or TiCN and the first metallic binder (3) is formed by Co, Ni, Fe or a base alloy of at least one of Co, Ni, Fe,
**characterized by**
a surface region (B) of the body (2) with a thickness (D) that is greater than the average grain size of the embedded hard-material particles (4), preferably greater than twice the average grain size of the embedded hard-material particles (4), and made of a composite material which comprises the hard-material particles (4) embedded into a second metallic binder (5) which comprises, as main constituent, at least one Cu and Ag.

10. Cemented-carbide product according to Claim 9, where the surface (O) of the body (2) is free from any continuous layer of the second metallic binder (5).

11. Cemented-carbide product according to Claim 9 or 10, where the hard-material particles (4) are formed at least predominantly by WC, and the first metallic binder (3) is formed by Co, Ni or a base alloy of at least one of Co and Ni.

12. Cemented-carbide product according to any of Claims 9 to 11, where the second metallic binder (5) is Cu or a Cu base alloy.

13. Cemented-carbide product according to any of Claims 9 to 12, where a polycrystalline diamond coating (7) is formed on the surface (O) of the body (2).

14. Cemented-carbide product according to Claim 13, where projections (6) made of the second metallic binder (5) protrude from the surface (O) and are embedded in the polycrystalline diamond coating (7).

15. Use of a cemented-carbide product according to any of Claims 9 to 12 as substrate for forming a polycrystalline diamond coating (7) on its surface (O).

## Revendications

1. Procédé de fabrication d'un produit de métal dur (1), comprenant les étapes suivantes :
- la fabrication par métallurgie des poudres d'un métal dur comprenant des particules de matière dure (4) incorporées dans un premier liant métallique ductile (3), les particules de matière dure (4) étant formées au moins principalement par WC ou TiCN et le premier liant métallique (3) étant formé par Co, Ni, Fe ou un alliage de base d'au moins un élément parmi Co, Ni, Fe,
- l'élimination sélective du premier liant métallique (3) dans la zone de la surface (O) du métal dur avec exposition au moins à proximité de la surface des particules de matière dure (4) dans cette zone, **caractérisé par** :
- l'infiltration des particules de matière dure exposées (4) avec au moins un élément parmi Cu, Ag ou un alliage de base de Cu ou Ag en tant que deuxième liant métallique (5) à une température inférieure au point de fusion du premier liant métallique (3) et supérieure au point de fusion du deuxième liant métallique (5), et
- l'élimination d'une couche continue du deuxième liant métallique (5) sur la surface (O), de telle sorte qu'un matériau composite, dans lequel les particules de matière dure (4) sont incorporées dans un matériau formé principalement par le deuxième liant métallique (5), reste sur la surface (O) en une épaisseur de couche (D), qui est supérieure à la taille de grain moyenne des particules de matière dure incorporées (4), de préférence ≥ 1 µm, de manière davantage préférée ≥ 3 µm.

2. Procédé selon la revendication 1, dans lequel les particules de matière dure (4) sont formées au moins principalement par WC et le premier liant métallique (3) est formé par Co, Ni ou un alliage de base d'au moins un élément parmi Co et Ni.

3. Procédé selon la revendication 1 ou 2, dans lequel l'élimination sélective du premier liant métallique (3) dans la zone de la surface (O) a lieu par décapage chimique ou électrochimique.

4. Procédé selon l'une quelconque des revendications précédentes, dans lequel le deuxième liant métallique (5) est Cu ou un alliage de base de Cu.

5. Procédé selon l'une quelconque des revendications précédentes, dans lequel l'élimination sélective du premier liant métallique (3) a lieu jusqu'à une profondeur d'au moins 2 µm de la surface (O), de préférence d'au moins 5 µm, de manière davantage préférée d'au moins 10 µm.

6. Procédé selon l'une quelconque des revendications précédentes, dans lequel, après l'élimination de la couche continue du deuxième liant métallique (5) sur la surface, un décapage sélectif de particules de matière dure (4) a lieu, de telle sorte que des traverses (6) en le deuxième liant métallique (5) dépassent de la surface (O).

7. Procédé selon l'une quelconque des revendications précédentes, dans lequel, après l'élimination de la couche continue du deuxième liant métallique (5) sur la surface (O), un revêtement de la surface (O) avec un revêtement de diamant polycristallin (7) a lieu.

8. Procédé selon la revendication 7, dans lequel le revêtement a lieu après un décapage sélectif de particules de matière dure (4).

9. Produit de métal dur (1), pouvant être fabriqué par un procédé selon l'une quelconque des revendications 1 à 8, comprenant :
un corps (2) en métal dur comprenant des particules de matière dure (4) incorporées dans un premier liant métallique ductile (3), les particules de matière dure (4) étant formées au moins principalement par WC ou TiCN et le premier liant métallique (3) étant formé par Co, Ni, Fe ou un alliage de base d'au moins un élément parmi Co, Ni, Fe,
**caractérisé par**
une zone de surface (B) du corps (2) ayant une épaisseur (D) qui est supérieure à la taille de grain moyenne des particules de matière dure incorporées (4), de préférence supérieure à deux fois la taille de grain moyenne des particules de matière dure incorporées (4), en un matériau composite, dans lequel les particules de matière dure (4) sont incorporées dans un deuxième liant métallique (5), qui comprend au moins un élément parmi Cu et Ag en tant que constituant principal.

10. Produit de métal dur selon la revendication 9, dans lequel la surface (O) du corps (2) est exempte d'une couche continue du deuxième liant métallique (5).

11. Produit de métal dur selon la revendication 9 ou 10, dans lequel les particules de matière dure (4) sont formées au moins principalement par WC et le premier liant métallique (3) est formé par Co, Ni ou un alliage de base d'au moins un élément parmi Co et Ni.

12. Produit de métal dur selon l'une quelconque des revendications 9 à 11, dans lequel le deuxième liant métallique (5) est Cu ou un alliage de base de Cu.

13. Produit de métal dur selon l'une quelconque des revendications 9 à 12, dans lequel un revêtement de diamant polycristallin (7) est formé sur la surface (O) du corps (2).

14. Produit de métal dur selon la revendication 13, dans lequel des traverses (6) en le deuxième liant métallique (5) dépassent de la surface (O) et sont incorporées dans le revêtement de diamant polycristallin (7).

15. Utilisation d'un produit de métal dur selon l'une quelconque des revendications 9 à 12 en tant que substrat pour la formation d'un revêtement de diamant polycristallin (7) sur sa surface (O).
